# EUROPÄISCHE PATENTSCHRIFT

(11) **EP 0 752 154 B1**
(45) Veröffentlichungstag und Bekanntmachung des Hinweises auf die Patenterteilung: **22.07.1998**
(21) Anmeldenummer: 95913041.0
(22) Anmeldetag: 21.03.1995
(51) Int. Cl.: H01H 50/14, H01R 9/09

(54) **LEITERPLATTENRELAIS MIT EINPRESSANSCHLÜSSEN**
PRINTED CIRCUIT BOARD RELAY WITH INSERT CONNECTIONS
RELAIS DE CARTES DE CIRCUITS IMPRIMES A CONNEXIONS ENCASTREES

(30) Priorität: 24.03.1994 DE 4410285
(43) Veröffentlichungstag der Anmeldung: 08.01.1997
(73) Patentinhaber: SIEMENS AKTIENGESELLSCHAFT, 80333 München (DE)
(72) Erfinder: DITTMANN, Michael, D-12207 Berlin (DE)
(86) Internationale Anmeldenummer: DE9500384
(87) Internationale Veröffentlichungsnummer: WO9526036

(56) Entgegenhaltungen:
- DE-A- 3 430 589
- DE-U- 8 431 966
- FR-A- 1 281 357
- US-A- 4 336 431

## Beschreibung

Die Erfindung betrifft ein Leiterplattenrelais mit einem Grundkörper, in welchem aus einer Blechplatine geschnittene Anschlußelemente im wesentlichen parallel zu einer Grundebene des Relais eingebettet sind, welche seitlich aus dem Grundkörper vortreten und an dessen Außenseite nach unten abgewinkelt sind, um senkrecht zur Grundebene stehende Einpreßstiele zu bilden.

Ein derartiges Relais ist bereits aus der DE 34 30 589 C2 in allgemeiner Form bekannt. Die Einpreßstiele sind dabei an den Kontaktelementen des Relais durch einfache Abwinkelung angeformt, wobei die elastische Einpreßzone durch einen Längsschlitz voneinander geteilte und auseinandergepreßte Schenkel aufweist.

Um bei der lötfreien Kontaktierung von Relais über Einpreßstiele auf einer Leiterplatte auch sicherzustellen, daß diese Kontaktierung gasdicht und zuverlässig ist, muß die Einpreßzone in der Lage sein, einen bestimmten Kontaktdruck in den Kontakt löchern der Leiterplatte zu erzeugen, was wiederum einen entsprechenden Einpreßdruck bei der Montage voraussetzt. Um nun diesen Einpreßdruck aufnehmen und übertragen zu können, benötigen die Einpreßstiele gemäß dem oben geschilderten Stand der Technik eine bestimmte Mindestmaterialstärke; anderenfalls besteht die Gefahr, daß die Einpreßstiele durch den Einpreßdruck geknickt werden. Da üblicherweise die Anschlußelemente einstückig aus dem Blechmaterial der Kontaktelemente geformt werden, die Blechstärke der Kontaktelemente bei Miniaturrelais jedoch vielfach sehr gering ist, beispielsweise nur 0,2 mm beträgt, ist für Einpreßstiele, die aus diesem Material geformt werden, die benötigte Steifigkeit nicht ohne weiteres gewährleistet.

Aus der DE-U-84 31 966 ist eine Kontaktfeder für elektrische Steckverbinderleisten bekannt, deren Anschlußfahne im Einpreßbereich V-förmig gestaltet ist, wobei Einpreßschultern symmetrisch an relativ kleinen Verbreiterungen der beiden Schenkel vorgesehen sind. Diese Einpreßschultern können Einpreßkräfte dann sicher übertragen, wenn die Materialstärke der Kontaktfeder ausreichend ist und das Einpreßwerkzeug relativ eng beiderseitig neben der Kontaktfeder angreifen kann. Diese Bedingungen sind bei Steckverbindern gegeben, nicht jedoch bei einem Relais der eingangs genannten Art.

Aus der US-A-4 336 431 ist weiterhin eine lötfreie Befestigung eines Feder-Blechelementes auf einer Leiterplatte dargestellt, wobei jeweils U-förmig gebogene Federelemente durch Einstecken in Löcher der Leiterplatte und durch anschließende Deformation durch Stauchen gesichert werden. Diese U-förmigen Federelemente besitzen zwar beiderseits rinnenförmig gebogene Lappen mit Einpreßschultern an ihrer Oberseite, doch handelt es sich nicht um Einpreßstiele im eigentlichen Sinne, da keine Kontaktierung der U-förmigen Federelemente in den Leiterplattenbohrungen stattfindet. Da die Feder-Blechelemente ohne jegliche Umspritzung oder Gehäuseumschließung verwendet sind, ist diese Gestaltung auch nicht auf die Kontaktierung der in einem Grundkörper eingebetteten Schaltkontakte eines Relais übertragbar.

Ziel der vorliegenden Erfindung ist es, bei einem Leiterplattenrelais der eingangs genannten Art die Einpreßstiele so zu gestalten, daß sie auch bei geringer Materialstärke eine ausreichende Steifigkeit besitzen, um in der Einpreßzone den erforderlichen Kontaktdruck zu erzeugen, und daß der Stiel selbst den hierzu erforderlichen Einpreßdruck auf die Einpreßzone zu übertragen vermag.

Erfindungsgemäß wird dieses Ziel bei einem Relais der eingangs genannten Art dadurch erreicht, daß die Einpreßstiele durch hülsen- oder rinnenförmig gebogene Abschnitte gebildet sind, welche mit senkrecht zur Grundebene stehender Achse jeweils an dem senkrecht nach unten abgewinkelten Abschnitt des jeweiligen Anschlußelementes einseitig derart angebunden sind, daß jeweils die Mitte der Hülse oder Rinne gegenüber diesem Abschnitt versetzt ist und zumindest ein Schenkel der Hülse oder Rinne sich außerhalb der Kontur des Relaisgrundkörpers befindet, wobei die Oberkante der Hülse oder Rinne eine Einpreßschulter bildet.

Bei der Erfindung sind die Einpreßstiele also nicht mehr nur als ebene Streifen aus dem Blechmaterial der Anschlußelemente geschnitten, sondern durch Biegen um eine Längsachse zu einer mehr oder weniger geschlossenen Hülse bzw. zu einer Rinne mit U-förmigem oder V-förmigem Querschnitt geformt, wodurch die Steifigkeit erheblich erhöht wird. Bei dieser an sich bekannten Rinnenform erhält die Einpreßzone ihre Elastizität nicht nur durch zwei dünne Schenkel zu beiden Seiten eines Schlitzes, sondern durch den gesamten Mantel der Rinne oder Hülse, der in sich federt.

Der obere Rand der den jeweiligen Einpreßstiel bildenden Hülse oder Rinne dient als Einpreßschulter, die im wesentlichen außerhalb der Außenkontur des übrigen Relaisaufbaus liegt, so daß diese Einpreßschultern für einen senkrecht einwirkenden Einpreßstempel zugänglich sind. Dies wird durch die einseitige Anbindung der Hülse oder Rinne an den abgebogenen Abschnitt des Anschlußelementes erreicht, wodurch die Mitte der Hülse gegenüber diesem Abschnitt versetzt ist und sich zumindest ein Schenkel der Hülse oder Rinne außerhalb der Kontur des Relaisgrundkörpers befindet. Durch diesen Versatz des wesentlichen Teiles des Einpreßstieles gegenüber dem aus dem Grundkörper austretenden Abschnitt des Anschlußelementes wird dieser leichter für ein Eindrückwerkzeug zugänglich. Insbesondere wird die Einpreßschulter über dem gebogenen und damit steifsten Bereich der Rinne ausgebildet; mit dem Einpreßstempel kann also von oben auf diese Einpreßschulter annähernd zentrisch zu dem rinnenförmigen Einpreßstiel gedrückt werden.

Dabei kann der Einpreßstempel unmittelbar auf die einzelnen Einpreßstiele drücken; es ist aber auch möglich, an einer Gehäusekappe eine seitliche Randleiste anzuformen, die den Einpreßdruck auf die einzelnen Einpreßschultern überträgt. Es wäre aber auch denkbar, die Einpreßschultern mit dem unmittelbar angrenzenden oberen Bereich der Einpreßstiele in eine Randleiste des Relais-Grundkörpers einzubetten und damit zusätzlich zu stabilisieren.

Zur weiteren Erhöhung der Steifigkeit bei besonders dünnem Blechmaterial ist es auch möglich, durch Faltung des Bleches im Bereich der Einpreßstiele eine doppelte Materialstärke zu erhalten, so daß die dann erzeugte Hülse oder Rinne einen doppelwandigen Mantel besitzt.

Die Erfindung wird nachfolgend an einem Ausführungsbeispiel anhand der Zeichnung näher erläutert. Es zeigt
Figur 1 ein erfindungsgemäß gestaltetes Relais in perspektivischer Ansicht von der Bodenseite her gesehen,
Figur 2 einen einzelnen Einpreßstiel in Detailansicht,
Figur 3 einen Schnitt durch ein Relais gemäß Figur 1 beim Einpressen in eine Leiterplatte,
Figur 4 einen Figur 3 entsprechenden Schnitt mit etwas abgewandelter Form des Relaisgehäuses.

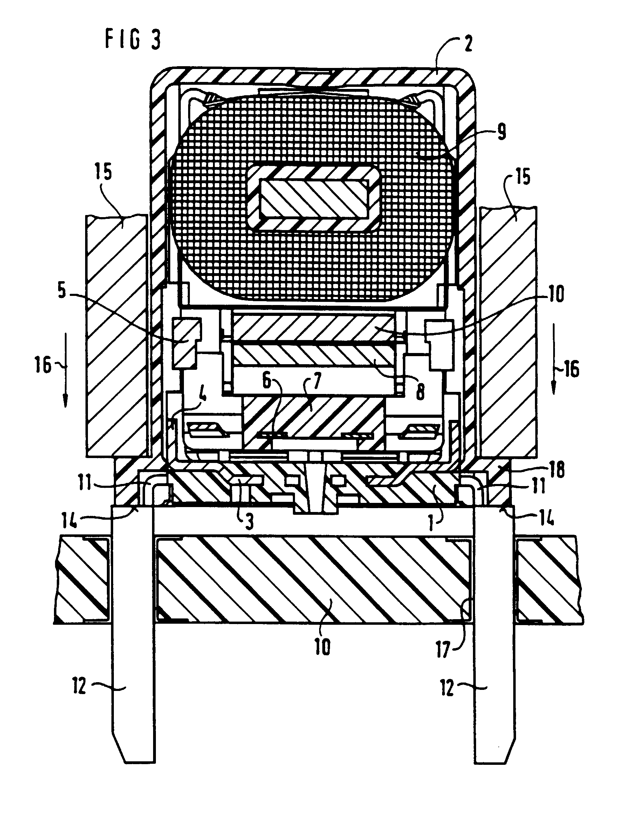

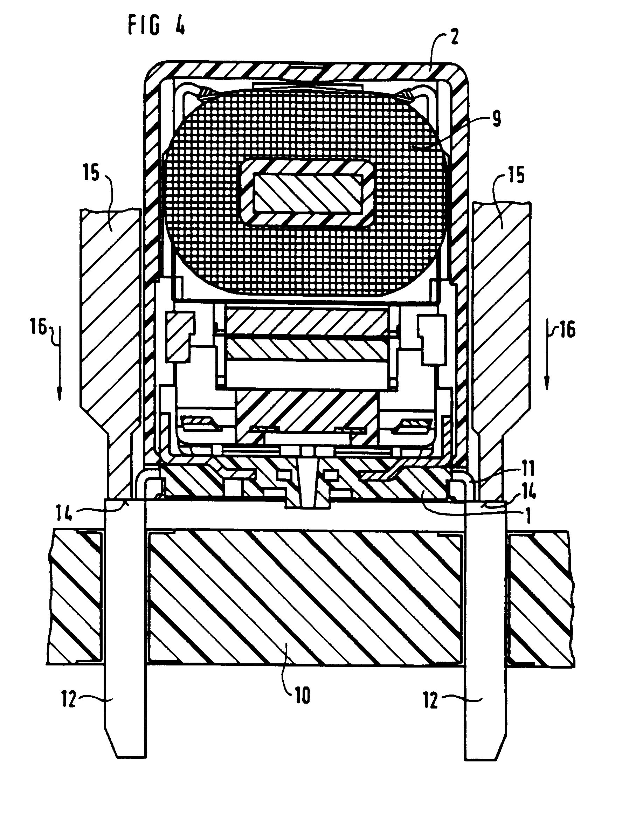

Das in der Zeichnung dargestellte Relais besitzt ein Gehäuse, welches aus einem als Grundkörper dienenden Sockel 1 und einer Gehäusekappe 2 besteht. In dem Sockel ist eine Blechplatine 3 im wesentlichen parallel zur Grundebene eingebettet. Aus der Blechplatine 3 sind nach oben in das Relaisinnere verschiedene feststehende Kontaktelemente 4 und Trägeranschlüsse 5 für bewegliche Kontaktelemente 6 gebogen. Diese beweglichen Kontaktelemente 6 sind über einen Isolierstoffträger 7 mit einem Anker 8 verbunden, der Teil eines eine Spule 9 und einen Dauermagneten 10 aufweisenden Magnetsystems ist. Dieser Relaisaufbau, wie er sich im Schnitt von Figur 3 bzw. Figur 4 präsentiert, ist an sich bekannt und soll deshalb hier nicht näher beschrieben werden.

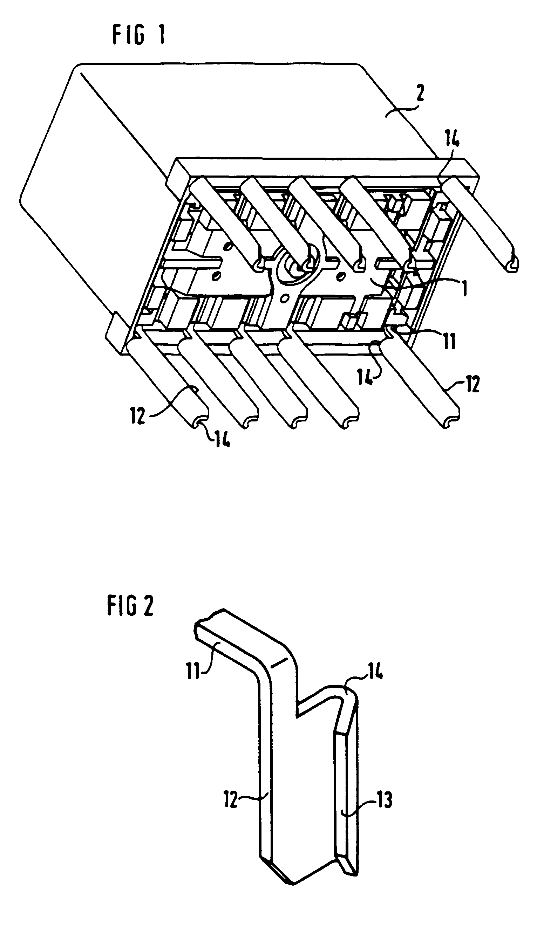

Zur Kontaktierung des Relais auf einer Leiterplatte 10 sind an der Blechplatine 3 auch Anschlußelemente 11 angeformt, die jeweils seitlich vom Relaissystem aus dem Sockel 1 austreten und nach unten abgewinkelt sind, um senkrecht zur Grundebene stehende Einpreßstiele 12 zu bilden. Wie in Figur 1 bzw. in Figur 2 zu sehen ist, sind diese Einpreßstiele 12 mit einem zusätzlichen Schenkel 13 in Form einer Rinne gebogen, so daß eine Einpreßzone mit U-förmigem oder V-förmigem Querschnitt entsteht. Denkbar wäre auch ein weiteres Einrollen zu einer oder mehr weniger geschlossenen Hülse. Der obere Rand des Einpreßstiels dient als Einpreßschulter 14, welche außerhalb der Gehäusekontur des Relais liegt und damit für ein Einpreßwerkzeug mit Stempeln 15 zugänglich ist. Diese Stempel 15 drücken in Richtung der Pfeile 16 auf die Einpreßschultern 14 und pressen damit die Einpreßzonen in die Kontaktbohrungen 17 der Leiterplatte 10.

Die Einpreßstiele 12 sind dabei asymmetrisch an das Anschlußelement angekoppelt, wobei der eine Schenkel des jeweiligen Einpreßstieles einseitig an den abgebogenen Abschnitt des Anschlußelementes 11 angeformt ist und an dessen Außenende über die V-förmige Abbiegung der zweite Schenkel 13 nach außen verläuft. Auf diese Weise wird die Einpreßschulter 14 über dem besonders steifen Mittelbereich des rinnenförmigen Einpreßstieles gebildet, und durch den Versatz zu der Anbindungsstelle kann mit dem Einpreßstempel auch annähernd zentrisch auf diesen steifen Abschnitt gedrückt werden.

Bei der Ausführungsform gemäß Figur 3 besitzt die Gehäusekappe 2 an ihrem unteren Rand jeweils eine angeformte Randleiste 18, die den Einpreßdruck der Stempel 15 auf die Einpreßschultern 14 überträgt. Gemäß der Ausführungsform von Figur 4 kann diese Randleiste auch entfallen, so daß die Einpreßstempel 15 unmittelbar auf die Einpreßschultern 14 der Einpreßstiele einwirken.

## Patentansprüche

1. Leiterplattenrelais mit einem Grundkörper (1), in welchem aus einer Blechplatine (3) geschnittene Anschlußelemente (11) im wesentlichen parallel zu einer Grundebene des Relais eingebettet sind, welche seitlich aus dem Grundkörper vortreten und an dessen Außenseite nach unten abgewinkelt sind, um senkrecht zur Grundebene stehende Einpreßstiele (12) zu bilden, **dadurch gekennzeichnet**, daß die Einpreßstiele (12) durch hülsen- oder rinnenförmig gebogene Abschnitte gebildet sind, welche mit senkrecht zur Grundebene stehender Achse jeweils an dem senkrecht nach unten abgewinkelten Abschnitt des jeweiligen Anschlußelementes (11) einseitig derart angebunden sind, daß jeweils die Mitte der Hülse oder Rinne gegenüber diesem Abschnitt versetzt ist und zumindest ein Schenkel (13) der Hülse oder Rinne sich außerhalb der Kontur des Relaisgrundkörpers (1) befindet, wobei die Oberkante der Hülse oder Rinne eine Einpreßschulter (14) bildet.

2. Relais nach Anspruch 1, **dadurch gekennzeichnet**, daß die Einpreßstiele (12) einen V-förmigen bzw. U-förmigen Querschnitt aufweisen.

3. Relais nach Anspruch 1 oder 2, **dadurch gekennzeichnet,** daß auf den Einpreßschultern (14) ein als Druckleiste dienender, nach außen vorstehender Rand (18) einer Gehäusekappe (2) liegt.

4. Relais nach Anspruch 1 oder 2, **dadurch gekennzeichnet,** daß die Einpreßschultern (14) außerhalb der Kontur einer Gehäusekappe (2) freiliegen.

5. Relais nach einem der Ansprüche 1 bis 4, **dadurch gekennzeichnet,** daß die Einpreßstiele (12) jeweils mit ihren an die Einpreßschulter (14) angrenzenden Bereich in einem seitlich angeformten Längssteg des Grundkörpers verankert sind.

6. Relais nach einem der Ansprüche 1 bis 5, **dadurch gekennzeichnet,** daß das Blech der Anschlußelemente im Bereich der Einpreßstiele zur Erzeugung einer doppelten Materialstärke gefaltet ist.

## Claims

1. Printed circuit board relay having a base body (1), in which connecting elements (11) which are cut from a sheet-metal panel (3) are embedded essentially parallel to a base plane of the relay, which connecting elements (11) project sideways from the base body and are bent downwards on its outer side in order to form push-in posts (12) which are at right angles to the base plane, characterized in that the push-in posts (12) are formed by sections which are bent in the form of sleeves or grooves and are in each case linked on one side to that section of the respective connecting element (11) which is bent downwards at right angles, having an axis which is at right angles to the base plane, in such a manner that the centre of the sleeve or groove is in each case offset with respect to this section, and at least one limb (13) of the sleeve or groove is located outside the contour of the relay base body (1), the upper edge of the sleeve or groove forming a pushing-in shoulder (14).

2. Relay according to Claim 1, characterized in that the push-in posts (12) have a V-shaped or U-shaped cross section.

3. Relay according to one of Claims 1 or 2, characterized in that an outwardly projecting rim (18), which is used as a pressure strip, of a housing cap (2) lies on the pushing-in shoulders (14).

4. Relay according to one of Claims 1 or 2, characterized in that the pushing-in shoulders (14) are exposed outside the contour of a housing cap (2).

5. Relay according to one of Claims 1 to 4, characterized in that the push-in posts (12) are anchored, in each case by means of their region which is adjacent to the pushing-in shoulder (14), in a longitudinal web of the base body, which longitudinal web is integrally formed at the side.

6. Relay according to one of Claims 1 to 5, characterized in that the metal sheet of the connecting elements is folded in the region of the push-in posts in order to produce twice the material thickness.

## Revendications

1. Relais de cartes de circuits imprimés comportant un corps de base (1), dans lequel des éléments de raccordement (11) découpés dans une plaque en tôle (3) sont intégrés pour l'essentiel parallèlement à un plan de base du relais, lesquels font saillie latéralement du corps de base et sont pliés vers le bas à sa face extérieure, pour former des tiges encastrées (12) disposées à la verticale du plan de base, **caractérisé en ce que** les tiges encastrées (12) sont formées par des sections en forme de douille ou de canal, lesquelles sont rattachées unilatéralement avec l'axe disposé à la verticale du plan de base à la section pliée verticalement vers le bas de l'élément de raccordement (11) respectif, de telle sorte que le centre de la douille ou du canal est décalé par rapport à cette section et qu'au moins une branche (13) de la douille ou du canal se trouve à l'extérieur du contour du corps de base du relais (1), l'arête supérieure de la douille ou du canal formant un épaulement encastré (14).

2. Relais selon la revendication 1, **caractérisé en ce que** les tiges encastrées (12) comportent une section transversale en forme de V ou en forme de U.

3. Relais selon la revendication 1 ou 2, **caractérisé en ce qu**'un bord (18) faisant saillie vers l'extérieur d'un couvercle de boîtier (2) et servant de barre de pression est posé sur les épaulements encastrés (14).

4. Relais selon la revendication 1 ou 2, **caractérisé en ce que** les épaulements encastrés (14) sont dégagés à l'extérieur du contour d'un couvercle de boîtier (2).

5. Relais selon l'une des revendications 1 à 4, **caractérisé en ce que** les tiges encastrées (12) sont chacune ancrées dans une barrette longitudinale du corps de base formé latéralement avec leur zone adjacente à l'épaulement encastré (14).

6. Relais selon l'une des revendications 1 à 5, **caractérisé en ce que** la tôle des éléments de raccordement est pliée dans la zone des tiges encastrées pour doubler l'épaisseur du matériau.
